# EUROPÄISCHE PATENTSCHRIFT

(11) **EP 0 766 908 B1**
(45) Veröffentlichungstag und Bekanntmachung des Hinweises auf die Patenterteilung: **16.12.1998**
(21) Anmeldenummer: 95923327.1
(22) Anmeldetag: 14.06.1995
(51) Int. Cl.: H05K 3/00, G03F 7/16

(54) **VERFAHREN UND VORRICHTUNG ZUM BESCHICHTEN VON LEITERPLATTEN, INSBESONDERE ZUR HERSTELLUNG VON MULTI-CHIP-MODULEN**
METHOD AND DEVICE FOR COATING PRINTED-CIRCUIT BOARDS, IN PARTICULAR FOR THE MANUFACTURE OF MULTI-CHIP-MODULES
PROCEDE ET DISPOSITIF PERMETTANT DE RECOUVRIR DES CARTES DE CIRCUITS, NOTAMMENT POUR PRODUIRE DES MODULES MULTIPUCES

(30) Priorität: 23.06.1994 DE 4421966; 12.08.1994 DE 4428713; 26.09.1994 DE 4434218; 12.12.1994 DE 4444086; 03.01.1995 DE 19500021; 23.03.1995 DE 19510227; 08.05.1995 DE 19516193
(43) Veröffentlichungstag der Anmeldung: 09.04.1997
(73) Patentinhaber: Schäfer, Hans-Jürgen, Dipl.-Ing., D-41749 Viersen (DE)
(72) Erfinder: Schäfer, Hans-Jürgen, Dipl.-Ing., D-41749 Viersen (DE)
(74) Vertreter: Stark, Walter, Dr.-Ing.
(86) Internationale Anmeldenummer: EP9502309
(87) Internationale Veröffentlichungsnummer: WO9600492

(56) Entgegenhaltungen:
- WO-A-92/07679
- DE-U- 9 407 930
- GB-A- 1 149 339
- GB-A- 2 111 313
- GALVANOTECHNIK, Bd.73, Nr.6, Juni 1982, SAULGAU/WURTT DE Seiten 696 - 698 R. KNIGGE 'Leiterplatten - Beschichtung und Trocknung'
- PATENT ABSTRACTS OF JAPAN vol. 18, no. 336 (E-1568) 24. Juni 1994 & JP,A,06 084 780 (DAINIPPON PRINTING CO) 25. März 1994

## Beschreibung

Die Erfindung betrifft ein Verfahren zum Beschichten von Leiterplatten mit einem durch elektromagnetische, vorzugsweise UV- Strahlung vernetzbaren Beschichtungsmittel gemäß Oberbegriff des Patentanspruchs 1. Die Erfindung betrifft auch eine dazu geeignete Vorrichtung gemäß Oberbegriff des Patentanspruchs 6.

Zur Herstellung von gedruckten Schaltungen , den sogenannten Leiterplatten, werden zur Leiterbilderzeugung sogenannte Ätzresiste im Siebdruckverfahren aufgetragen,die der Struktur des gewünschten Leiterbildes entsprechen. Es handelt sich hierbei um Lacksysteme, die durch Trocknung oder UV-Strahlung eine klebfreie ätzmittelbeständige Oberfläche erhalten und nach dem Ätzen des Leiterbildes mit sogenannten Strippern in 5 % iger Kalilauge wieder entfernt werden.

Diese Art der Leiterbilderzeugung ist die preiswerteste und wird daher überwiegend in der Konsumelektronik angewandt. Es lassen sich mit dieser Technik nur Leiterbreiten bis 300 µm mit ausreichender Genauigkeit reproduzieren. In der kommerziellen Elektronik ist man in den letzten zwanzig Jahren dazu übergegangen,das Leiterbild fotografisch zu erzeugen. Hierzu wurden sogenannte Trockenfilmresiste mit Rollen auf Leiterplatten auflaminiert. Das Leiterbild wird unter Verwendung einer Fotomaske durch UV-Strahlung fixiert, wobei je nach Verfahren, entweder die Leiter oder die leiterfreien Bereiche fotopolymerisiert werden.

Die Bilderzeugung für die reine Ätztechnologie benötigt jedoch nur Schichtdicken von wenigen Mikrometern.Da dies mit Folien nicht realisierbar ist, trägt man fotosensible Flüssigresiste beidseitig mit profilierten Walzen auf. Die Art und Anzahl der Profilrillen bestimmen die Auftragsmenge. Es handelt sich somit um einen durch das Profilvolumen definierten Auftrag, wobei die Auftragswalzen als Schöpfwalzen dienen. Die Profilrillen ermöglichen einen definierten Volumenauftrag bei niedriger Viskosität und hohem Anpreßdruck.

Nach der Erzeugung des Leiterbildes wird die Schaltung mit einer Lötstoppmaske versehen, die nur noch die zu lötenden Bereiche freiläßt. Diese Lötstoppmaske wird ebenfalls im Siebdruckverfahren aufgetragen und sowohl thermisch als auch durch UV-Strahlung ausgehärtet.

Für die kommerzielle Leiterplattentechnik war auch dieses Siebdruckverfahren mit zunehmender Integration nicht mehr einsetzbar.

Daher wurde in der EP Al 0002 040 ein Verfahren zur Auftragung eines flüssigen Fotopolymers im Vorhanggußverfahren vorgeschlagen.

Desweiteren werden in der DE 36 13 107 Al Resistfarbenzusammensetzungen beschrieben, die im Siebdruck mit einem Leersieb ganzflächig aufgetragen werden und mit UV-Strahlung fotostrukturierbar sind. Darüberhinaus werden auch Trockenfilmresiste mit Laminierwalzen unter Vakuumanwendung aufgetragen. Das Vorhanggußverfahren hat seine Grenzen im hohen Lösungsmittelgehalt und kann daher nicht für dickere Schichten eingesetzt werden.

Das Siebdruckverfahren hat seine Grenzen in der Technologie des Siebes, so daß keine Schichtdicken von 10 µm und auch keine Schichtdicken von 100 µm in akzeptabler Qualität aufgetragen werden können.

Der Trockenfilm kann ebenfalls nicht in Schichtdicken von 10 µm aufgetragen werden, dickere Schichten können nicht für die Herstellung von Mehrlagenschaltungen der Multi- Chip- Modulen verwendet werden, da sie nicht metallisierbar sind.

In der WO 92 / 07 679 wird ein Walzenbeschichtungsverfahren zur ein- und beidseitigen Beschichtung von Leiterplatten, insbesondere mit Lötstopplack, beschrieben. Dieses Verfahren arbeitet in einem Viskositätsbereich von 300 bis 5000 mPas. Zur Erzielung einer Leiterabdeckung von 2 bis 10 µm, die keineswegs den Anforderungen der Leiterplattentechnologie genügt, ist nach einer Zwischentrocknung ein zweiter Beschichtungsvorgang erforderlich. Dies ist weder wirtschaftlich noch qualitativ vertretbar.

In der PTC / IB 94 00102 wird ein Walzenbeschichtungsverfahren beschrieben, das von einer einmaligen Beschichtung mit schmelzbaren Resisten bei hoher Temperatur ausgeht. Dieses Verfahren ist nur mit neuentwickelten schmelzbaren Beschichtungsmitteln durchführbar. Eine Verwendung marktgängiger Resiste ist nicht möglich, da keine schmelzbaren Resiste verfügbar sind.

Für die erfindungsgemäße Anwendung zur Herstellung von Multi- Chip- Modulen ist darüberhinaus ein hoher Füllstoffanteil erforderlich, der sich in einem schmelzbaren Resist nur schwer realisieren läßt.

Die weiter fortschreitende Miniaturisierung führt zu integrierten Schaltungen mit immer höheren Anschlußzahlen, so daß Anschlußpads mit Breiten kleiner 0,5 mm erforderlich werden.

Während eine Entwicklungsrichtung versucht, die "fine pitches" mit massiven Lotdepots zu beherrschen, wie dies in der DE 41 37 045 A1 beschrieben ist; versucht eine andere Entwicklung auf mehrere Ebenen auszuweichen und 4-lagige Schaltungen zu entwickeln, die auf den Außenlagen ein sogenanntes " pads only design " haben, so daß Padbreiten von 100 µm realisierbar sind. Derartige Schaltungen werden auch als Multi- Chip- Module bezeichnet, da sie mit einem Raster von 2mm breiten Anschlüssen sehr einfach auf Leiterplatten aufgelötet werden können.

Derartige Multi- Chip- Module werden in der Zeitschrift Galvanotechnik Nr.1 1994 als DYCOstrate Schaltungen beschrieben. Hier dient flexibles Polyimid Basismaterial als Konstruktionsgrundlage. Da die Bohrungen den meisten Platz benötigen, nutzt dieses Verfahren die Möglichkeit, Mikrobohrungen von 50 µm durch Plasmabehandlung in die Polyimidfolie ätzen zu können. Der Prozeß ist jedoch sehr aufwendig, insbesondere durch die dünnen teuren Substrate.

In der Zeitschrift Galvanotechnik Nr.12 1994 wird der sogenannte BUM (build up multilayer board) Prozeß beschrieben.

Hierbei werden auf gedruckte Schaltungen sogenannte " via sheet " Kupferfolien benötigt. Es handelt sich hierbei um Kupferfolien, die in zwei Beschichtungsschritten mit einem isolierenden Harz beschichtet sind, wobei die erste Schicht weit vorgehärtet ist. Diese Folie wird derart auf die Leiterplatte mit einem Rollenlaminator auflaminiert, daß die Leiter luftblasenfrei ummantelt sind. Dies ist nur unter Vakuumanwendung möglich. Es handelt sich bei dem Laminieren um einen sehr empfindlichen Prozeß, zumal die zweimalige Beschichtung der Kupferfolie schon zu erheblichen Beschädigungen der Kupferfolie führt. Jeder Staubpartikel von größer 30 µm führt zu Löchern im Kupfer und somit zur Unbrauchbarkeit. Die Löcher lassen sich erst nach dem Laminieren feststellen und führen dann zum Ausschuß der gesamten Schaltung.

Diese Probleme bei den derzeitigen Verfahren zeigen, wie dringend hier nach Wegen zur Lösung dieser technologischen Herausforderung gesucht wird. Es werden erhebliche Schwierigkeitsgrade sowohl beim DYCO strate Verfahren mit flexiblen Polyimidfolien , sowie beim BUM- Prozeß mit zweifacher Beschichtung der Kupferfolie in Kauf genommen, um die Zukunftsanforderurungen der neuen hochintergrierten Bauteilgeneration zu lösen.

Der vorliegenden Erfindung liegt daher die Aufgabe zugrunde, ein einfaches, technisch leicht beherrschbares, kostengünstiges Verfahren zur Verfügung zu stellen, mit dem die beidseitige Beschichtung von Leiterplatten inDicken von 10 bis 200 µm möglich ist, so daß die Herstellung von zwei Außenlagen für ein " pads only design " über eine 100 µm dicke flammenwidrige , fotopolymerisierbare und chemisch verkupferbare Isolationsschicht erreicht wird. Hierzu sollen Microbohrungen von 50 µm Durchmessern durch Fotostrukturierung erzeugt und die Leiter und IC-Anschlüsse im Semiadditivverfahren hergestellt werden.

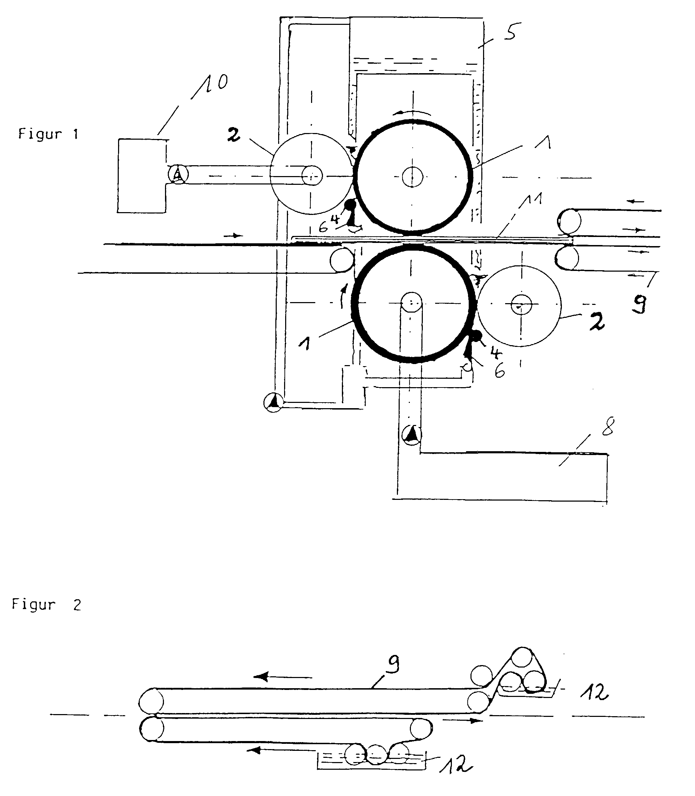

Die Lösung all dieser und noch weiterer damit in Verbindung stehender Aufgaben erfolgt durch ein Verfahren und eine Vorrichtung gemäß der unabhängigen Patentansprüche 1 und 6. Besonders bevorzugte Varianten des erfindungsgemäßen Verfahrens bzw. zugehörigen erfindungsgemäßen Vorrichtung sind jeweils Gegenstand der entsprechenden abhängigen Verfahrens - bzw. Vorrichtungsansprüche. Insbesondere wird durch die Erfindung ein Verfahren zum Beschichten von Leiterplatten mit einem durch elektromagnetische Strahlung, vorzugsweise UV- Strahlung vernetzbaren Schaltungsdrucklack geschaffen, das sich durch folgende Verfahrensschritte auszeichnet : Wie in Figur 1 dargestellt, wird ein fotopolymerisierbares 70 bis 95 Gew.% iges Beschichtungsmittel mit einer Viskosität von 10 bis 20 Pa.s bei 25 °C auf 30 bis 50 °C vorerwärmt, mit einer Viskosität von 1 bis 10 Pa.s aus einem Vorratsgefäß 5 einer zweiseitigen Walzenbeschichtungsanlage zugeführt, deren Dosierwalzen 2 durch eine Thermostatisierung im Bereich von 25 bis 60 °C die Viskosität konstant halten und die Pumpfähigkeit gewährleisten. Der Thermostat 10 ist an die Dosierwalzen 2 angeschlossen, der Vorratstank 5 ist darüber angeordnet. Die Dosierwalzen 2 bilden mit den glatten geschliffenen gummierten Auftragswalzen 1 einen Spalt, der die gewünschte Filmdicke definiert. Die 10 bis 20 mm dicke Gummierung ist mit einer diagonalen oder oszillierenden Rillung von 100 bis 500 µm Breite versehen, die mit einer weicheren Gummischicht von 10 bis 20 shore Härte A ausgefüllt und deren Oberfläche glattgeschliffen wird. Die Auftragswalzen 1 sind gekühlt, so daß eine Oberflächentemperatur von 5 bis 20 °C erzielt wird. Der Beschichtungsfilm wird auf eine Auftragsviskosität von 20 bis 100 Pa.s gebracht, so daß es möglich wird, hohe lösungsmittelhaltige Schichtdicken aufzutragen. Die hohe Viskosität sorgt zusammen mit der speziellen Walzenoberfläche für eine gute Anpassung an hohe Leiter und verhindert ein Abquetschen. Das Kühlaggregat 8 sorgt für eine gleichmäßige Beschichtungstemperatur. Auf diese Weise wird mit einer Beschichtungsgeschwindigkeit von 5 bis 20 m / min beidseitig eine 50 bis 100 µm dicke Schicht eines fotoplymerisierbaen Beschichtungsmittel aufgetragen.

Aus Figur 1 wird deutlich,daß für den Transport und die Trocknung des Films die Leiterplatte 11 einen beschichtungsfreien Rand hat.

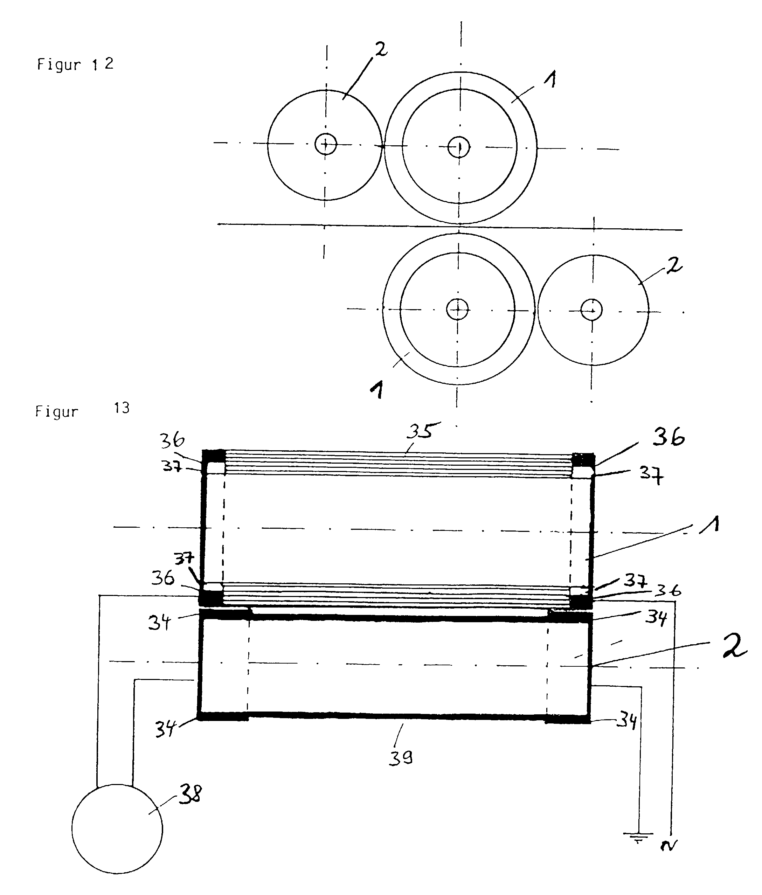

Dieser wird durch die Anbringung eines beheizbaren Rollrakels 4 an die Auftragswalzen 1 erreicht, der von einem Messerrakel 6 gereinigt wird. Das abgestreifte Beschichtungsmittel wird in den Vorratstank 5 zurückgeführt. Zum Auftragen bevorzugter Schichtdicken mit einer Toleranz von kleiner 10 % in Dicken 10 µm , 50 µm und 100 µm wird eine in Figur 12 dargestellte Walzenanordnung verwendet, die im Randbereich der Dosierwalzen 2 eine galvanische Metallisierung in der gewünschten Beschichtungsdicke aufweist. Hierbei handelt es sich um Chrom-bzw. Chrom / Nickel in den Dicken 10 µm, 50 µm und 100 µm. Über diese auf einer beliebigen Breite von ca. 1 bis 20 cm galvanianisch aufgebrachten Metallschicht läßt sich ein Höchstmaß an Parallelität erreichen.

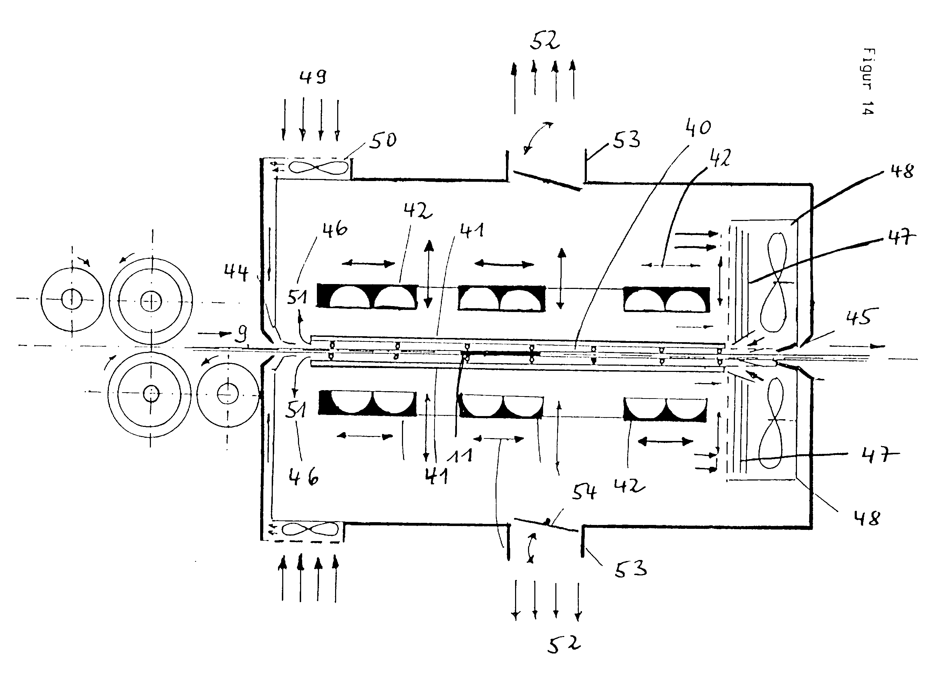

Gleichzeitig läßt sich die Rundlaufgenauigkeit ermitteln, wenn diese Metallschicht Ihren Kontakt zur gummierten Auftragswalze 1 verliert. Um eine gleichmäßige Dicke des Beschichtungsfilms sicher zu stellen, muß gewährleistet werden, daß diese Metallschicht im Kontakt mit der Auftragswalze 1 bleibt, ohne in die Gummierung einzudringen. Dies wird in der in Fig. 13 dargestellten Weise durch das Anbringen eines elektrischleitfähigen Gleitkontaktringes erzielt 36 ,der an die Gummierung 35 am Rand aufgesetzt, und auf gleiche Dicke geschliffen wird. Wird an den leitfähigen Gleitkontakring 36 Spannung angelegt, so beginnt der Strom zu fließen sobald beide Ringe 36 Kontakt mit der Metalldistanzschicht 34 der Dosierwalze 2 haben. Sollten mangelhafte Rundlaufeigenschaften zur Kontaktunterbrechung führen, so kann dies über ein Spannungsmeßgerät 38 erfaßt und über eine Steuerung korrigiert bzw. die Anlage abgeschaltet werden. Der leitfähige Gleitkontaktring 36 sollte eine änhliche thermische Außdehnung wie Gummi besitzen, jedoch nicht verformbar sein. Eine Isolation 37 zum Metallkern der Auftragswalze 1 sollte gewährleistet sein.

Über einen Schreiber läßt sich nun der gleichmäßige Stromfluß dokumentieren, so daß eine aufwendige Untersuchunp an den Leiterplatten 11 nicht erforderlich ist. Der Abstand zwischen den beiden Metalldistanzschichten 34 bestimmt die Beschichtungsbreite 39 . Diese erfindungsgemäße Vorrichtung ermöglicht es erstmalig bei Schichtdicken unter 100 µm eine gleichmäßige Schichverteilung sowohl über die Leiterplattenbreite wie über die Länge zu gewährleisten, ohne daß hierzu Messungen auf der beschichteten Leiterplatte 11 notwendig sind. Gleichzeitig wird ein beschichtungsfreier Rand erzeugt, der für den Weitertransport der Leiterplatten 11 in den Trockner erforderlich ist. Wie aus Figur 2 ersichtlich ist, werden diese Leiterplatten mit breitenverstellbaren rollengeführten Doppelbändern 9 transportiert, die im Rücklauf vor dem Trockner durch ein Lösungsmittelbad 12 gereinigt werden.

Die Trocknung erfolgt erfindungsgemäß mit einem Infrarot-Konvektionstrockner, wie er in Figur 14 dargestellt ist.

Um dicke Lackschichten von größer 50 µm möglichst schnell staubfrei trocknen zu können, wird ein Trockner verwendet, der einen 20 bis 150 mm hohen, 300 bis 700 mm breiten und 3 bis 10 m langen Trockenkanal 40 besitzt, in den vorgewärmte Luft mit hoher Geschwindigkeit von 5 bis 40 m / s gegen die Transportrichtung über Breitschlitzdüsen 41 eingeblasen wird,welche oberhalb und unterhalb der Leiterplattentransporteinrichtung 9 angebracht sind. Diese hohe Luftgeschwindigkeit sorgt für eine schnelle Trocknung und führt gleichzeitig dazu, daß Staubpartikel in Schwebe gehalten werden , und nicht auf die zu trocknende Lackoberfläche gelangen. Außerdem kann durch die Einstellung unterschiedlicher Strömungsgeschwindigkeiten ein Auftrieb erzeugt werden, der zur Mittenunterstützung der Leiterplatten 11 beiträgt. Der Trockenkanal 40 ist ist auf der Ober- und Unterseite mit Glasscheiben 41 abgedeckt, durch die Infrarotstrahler 42 mit einer Wellenlänge von 1 bis 10 µm, welche vertikal und horizontal beweglich angebracht sind, die Leiterplatte 11 erwärmen. Somit kann das Trockentemperaturprofil an die Lackschichtdicke inviduell angepaßt werden.

Der Trocknereinlaß 44 und der Austritt 45 sind düsenförmig gestaltet. Die Luft 46 wird als Umluft geführt. Sie wird sowohl durch die Strahler 42 wie auch durch die Wärmetauscher 47 auf eine regelbare Temperatur aufgewärmt. Der Umluftventilator 48 ist am Ende des Trockners angebracht und saugt die Luft aus dem Strahlerraum an, um sie mit hoher Geschwindigkeit durch den Trockenkanal 40 im Gegenstrom zu blasen. Die Frischluft 49 wird mit einem Frischluftventilator 50 , der aus der Abluft der an den Trockner angeschlossenen Kühleinheit versorgt wird, in den Trocknereinlaß über zwei jeweils über und unter der Transporteinrichtung angebrachten Breitschlitzdüsen 44 geblasen und vermischt sich mit der aus dem Trockenkanal 40 austretenden lösungsmittelhaltigen Luft 51 . Die Abluft 52 wird über eine Abluftöffnug 53 aus dem Trockner abgeführt, wobei die Menge über eine Abluftklappe 54 geregelt wird. Auf diese weise können 50µm dicke Lackschichten mit einem Lösungsmittelanteil von 10 bis 20 Gew.% in 60 sek. getrocknet werden.

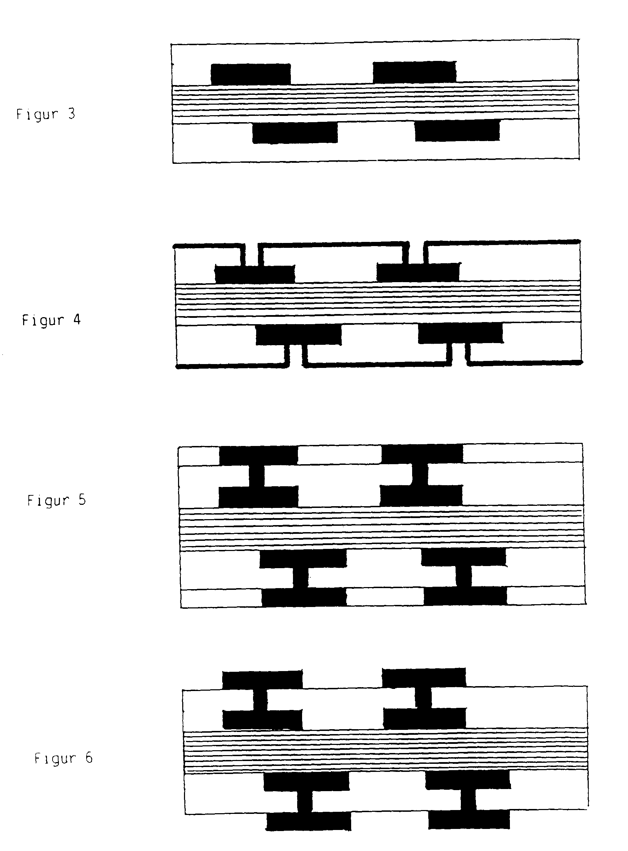

In den Figuren 3 bis 6 werden Verfahrensschritte dargestellt , wie aus einer Leiterplatte Mult-Chip- Module hegestellt werden können.

Wie aus der Figur 3 ersichtlich, wird auf eine Leiterplatte eine 100µm dicke Schicht eines fotopolymerisierbaren, thermisch härtbaren, flammenwidrigen und nach Säureaufrauhung verkupferbaren Beschichtungsmittels im erfindungsgemäßen Beschichtungsverfahren aufgetragen.

Die Flammenwidrigkeit und die Verkupferbarkeit wird durch Zusatz eines Füllstoffes zu handelsüblichen füllstofffreien Beschichtungsmitteln erreicht. Bei diesem säurelöslichen und flammenwidrigem Füllstoff, der eine ausreichend hohe thermische Stabilität besitzt, handelt es sich um Magnesiumhydroxid. Dieses Beschichtungsmittel wird nach der Trocknung im Tockenofen mit UV-Strahlen der Wellenlänge 350 bis 400 nm unter Verwendung einer negativ- Lochmaske welche Löcher von 50 µm Durchmessern besitzt, belichtet. Die Figur 4 zeigt, wie die unvernetzten Beschichtungsmittelanteile aus den Löchern freientwickelt werden. Anschließend wird die Oberfläche und die Lochwandung mit Schwefelsäure aufgerauht und chemisch mit einer o,5 bis 1 µm dicken Kupferschicht 15 belegt. Nach der Fotostruktrierung der Pads (IC- Anschlüsse ) in Breiten von 100 bis 200 µm werden die Bohrungen und Pads galvanisch bis auf die Dicke von 20 µm verstärkt. Vergleichbar mit der Semi- Additivtechnik wird das Beschichtungsmittel nach der galvanischen Verkupferung mit 5 % iger Kalilauge gestrippt und wie die Figur 6 zeigt, das Leiterbild durch Differenzätzung erzeugt.

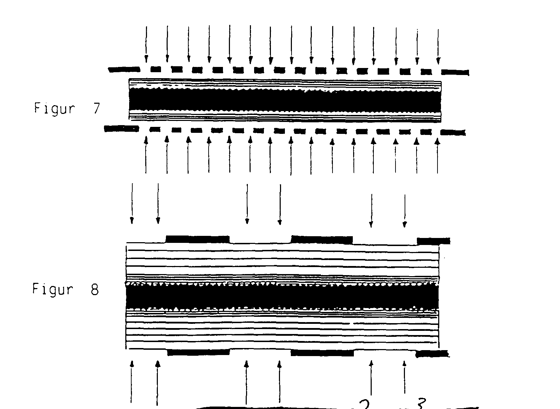

In einer besonderen Ausführung des erfindungsgemäßen Verfahrens können auch Schaltungen in der Semi - Additivtechnik hergestellt werden. Hierzu werden wie in Figur 7 dargestellt unkaschierte Leiterplatten mit 10 bis 20 µm eines Beschichtungsmittels beschichtet. Nach der Trocknung wird dieses Beschichtungsmittel mit Hilfe einer Lochmaske mit Lochdurchmessern von 20 µm und Abständen von 10 µm fotostrukturiert, über diese erste Schicht des fotostrukturierten Beschichtungsmittels wird eine zweite Schicht aufgetragen, wie dies in der Figur 8 dargestellt ist. Diese wird dann mit UV -Strahlung unter Auflage einer Leiterbildfolie belichtet.

Hierdurch werden die leiterfreien Bereiche vernetzt.

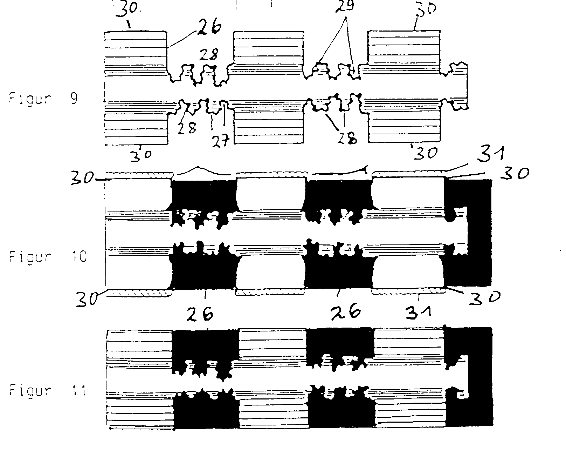

In der Figur 9 wird dargestellt, wie die Leiter 26 freientwickelt werden und hierdurch auf dem Leiterhaftgrund säulenförmige Bereiche 28 entstehen, die zwischen sich Kavernen 29 ausbilden, so daß eine gute Verankerung der Kupferschicht 30 gewährleistet ist.

Im Anschluß an die Entwicklung und Trocknung wird die Oberfläche des Beschichtungsmittels mit Schwefelsäure aufgerauht und chemisch auf 1 µm verkupfert 30 .

Die Figur 10 zeigt, wie nach der Verkupferung in einem dritten Beschichtungsprozeß eine 20 µm dicke Schicht eines Beschichtungsmittels 31 als Galvanoresist derart auf die Leitkupferschicht 30 aufgetragen wird, daß die Kanäle der Leiter 26 unbeschichtet bleiben.

Nach der Trocknung werden die Leiter 26 galvanisch auf 40 µm verkupfert. Die Figur 11 zeigt eine Schaltung, die durch Strippen mit 5 % iger Kalilauge vom Galvanoresist befreit wird und bei der die Leitkupferschicht 30 mit Ammonpersulfat weggätzt wird.

Diese Schaltung kann nun mit 50 µm Beschichtungsmittel beschichtet und in der beschriebenen Weise zu Multi - Chip- Module verarbeitet werden.

### Beispiele :

### Beispiel 1

Es werden Lötstoppmasken inDicken von 50 µm durch Auftrag von lösungsmittelarmen hochviskosen Beschichtungsmitteln im Walzenbeschichtungsverfahren hergestellt.

| | | |
|---|---|---|
| Leiterplatte | Basismaterial FR 4 | 1,6 mm |
| | Leiterhöhe | 50 µm |
| | Leiterbreite | 150 µm |
| | Temperatur | 25 °C |

### Beschichtungsmittel 1: Siebdruckfähige Resistfarbenzusammensetzung gem. DE 36 13 107 Al Beispiel 4

| Komponente A | |
|---|---|
| Harz ( A - 3 ) | 50 Gew.Tl.70 % in Cellosolvacetat |
| Trimethylolpropantriacrylat | 4 Gew.Tl. |
| Pentaerythrittriacrylat | 4 Gew.Tl. |
| 2-Ethylanthrachinon | 3 Gew.Tl. |
| 2-Phenyl-4-benzyl-5hydroxy-methylimidazo | 10,5 Gew.Tl. |
| " AC - 300 " | 1,0 Gew.Tl |
| Phthalocyaningrün | 0,5 Gew.Tl |
| Calciumcarbonat | 10 Gew.Tl. |
| | 75 Gew.Tl. 80 Gew.% |
| | |

| Komponente B | |
|---|---|
| " Epiclon EXA 1514 " bis Phenol-s-Typ Epoxidharz von Dai-Nippon Ink& Chemical | 10 Gew.Tl. |
| Trimethylolpropantriglycidylether | 4 Gew.Tl. |
| Cellosolvacetat | 6 Gew.Tl. |
| Calciumcarbonat | 5 Gew.Tl. |
| | 25 Gew.Tl. 80 Gew.% |

### Beschichtungsmittel 1:

75 Gew.Tl Komponente A und 25 Gew.Tl. Komponente B 80 Gew.% 25 Pa.s 25°C

### Beschichtungsanlage :

Walzenbeschichtungsanlage gem. Figurl Gummierung 20 mm Härte A 50 shore Rillung 200 µm diagonal 45 ° Füllung Gummi Härte A 20 shore

| | |
|---|---|
| Temperatur Auftragswalze | 5 °C |
| Temperatur Rakel | 90 °C |
| Temperatur Dosierwalze | 40 °C |
| Auftragsviskosität | 65 Pa.s |
| Wannenviskosität | 2 Pa.s |
| | |
| Beschichtungsgeschwindigkeit | 15 m/min |
| Walzenspalt | 60 µm |
| Schichtdicke | 50 µm |
| | |
| Trocknung IR1 bis 10µm | 120 sek |
| Temperatur | 120 °C |
| Belichtung UV 360 nm | 60 sek |
| Entwicklung in 1%iger Na₂CO₃ | 90 sek |
| Aushärtung 150 °C | 30 min |

### Ergebnis : Leiterabdeckung 25 µm Kantenabdeckung 13 µm

### Beispiel 2

Herstellung von Multi - Chip - Modulen durch Beschichten von in Subtraktiv - oder Addiv technik hergestellten Leiterplatten mit 100 µm dicken Schichten eines losungsmittelarmen fotopolymerisierbaren , chemisch verkupferbaren und thermisch härtbaren flammenwidrigen Beschichtungsmittel.

Lelterplatte : Basismaterial FR 4 1,6 mm wie Beispiel 1

### Beschichtungsmittel 2

Siebdruckfähige Resistfarbenzusammensetzung gem DE 36 13 107 A1 Beispiel 4

| Komponente A | |
|---|---|
| Harz ( A - 3 ) | 50 Gew.Tl.70% Cellosolvacetat |
| Trimethylolpropantriacylat | 4 Gew.Tl. |
| Pentaerythrittriacrylat | 4 Gew.Tl. |
| 2-Ethylanthrachinon | 3 Gew.Tl. |
| 2-Phenyl-4-benzyl-5-hydroxy-methylimidazol | 0,5 Gew.Tl. |
| " AC - 300 " | 1,0 Gew.Tl. |
| Phtalocyaningrün | 0,5 Gew.Tl |
| Magnesiumhydroxid | 10 Gew.Tl. |
| | 75 Gew.Tl. 80 Gew.% |

| Komponente B | |
|---|---|
| " Epiclon EXA 1514 bis Phenol -S-Typ Epoxidharz von Dai-Nippon Ink&Chemical | 10 Gew.Tl. |
| Trimethylolpropantriglycidylether | 4 Gew.Tl. |
| Magnesiumhydroxid | 11 Gew.Tl. |
| | 25 Gew.Tl. 100 Gew.% |

### Beschichtungsmittel 2

75 Gew.Tl. Komponente A und 25 Gew.Tl. Komponente B 85 Gew.% 50 Pa.s 25°C

### Beschichtungsanlage :

Walzenbeschichtungsanlage gem. Figur 1 Gummierung 20 mm Härte A 40 shore

| | |
|---|---|
| Temperatur Autragswalze | 10 °C |
| Temperatur Rakel | 90 °C |
| Temperatur Dosierwalze | 50 °C |
| Auftragsviskosität | 90 Pa.s |
| Wannenviskosität | 2 Pa.s |
| Beschichtungsgeschwindigkeit | 5 m/min |
| Walzenspalt | 120 µm |
| Schichtdicke | 100 µm |
| Trocknung IR 1-10 µm | 120 sek |
| Temperatur | 100 °C |
| Belichtung UV 360 nm | 90 sek Fotofolie Lochdurchmesser 50µm |
| Entwicklung in 1%iger Na₂CO₃ | 120 sek |

### Verkupferung chemisch 1 µm

| | |
|---|---|
| Ätzen in konz.Schwefelsäure | 60 sek RT |
| Neutralisieren KOH 1n | 5 min RT |
| Konditionieren | 10 min 70 bis 80°C |
| Bekeimen ( Palladium ) | 5 min 42 bis 46°C |
| Beschleunigen | 5 min RT |
| chemisch verkupfern 1 µm | 30 min 45 bis 48°C |

Tempern 1 Stunde 100 °C

### Beispiel 3

Beschichten der chemisch in Loch , Bohrung und auf der Oberfläche verkupferten Leiterplatte mit einer 20 µm Schicht des Beschichtungsmittels 1 , Belichten mit Leiterbild ( IC -Anschlüsse 200 µm ) ,entwickeln , galvanisch auf 20 µm verkupfern , Strippen in 5 % iger KOH und Differenzätzen in Ammoniumpersulfat.

| | |
|---|---|
| Beschichtungsmittel | Beschm.1 Beispiell verd.auf 70% 2 Pa.s 25°C |
| Beschichtungsanlage | Walzenbeschichtungsanlage gem.Figur 1 Gummierung Härte A 60 shore |
| Temperatur Auftragswalze | 15 °C |
| Temperatur Rakel | 90 °C |
| Temperatur Dosierwalze | 25 °C |
| Auftragsviskosität | 20 Pa.s |
| Wannenviskosität | 2 Pa.s |
| Beschichtungsgeschwindigkeit | 20 m/min |
| Walzenspalt | 25 µm |
| Schichtdicke | 21 µm |
| Trocknung IR 1 bis 10 µm | 60 sek |
| Temperatur | 80 °C |
| Belichten UV 360 nm | 60 sek |
| Entwickeln in 1% Na₂CO₃ | 60 sek |

### Galvanisch auf 20 verkupfern

| | |
|---|---|
| Stromdichte 1,8 A /qdm : | 30 min |
| Strippen KOH 5 % , Atzen 1 µm Cu in Ammoniumpersulfat | |
| Aushärten 150 °C : | 60 min |

### Beispiel 4

Herstellung von Multi-Chip- Modulen in Semiadditivtechnik durch Beschichten eines unkaschierten Substrates mit 10µm des Beschichtungsmittels 2, Fotostrukturierung des Leiterhaftgrundes durch Belichtung mit UV-Strahlung unter Verwendung einer Lochrasterfolie mit 20µmDurchmessern und 10 µm Abstand. Beschichtung mit einer 30 µm dicken Schicht des Beschichtungsmittels 2 , Belichtung mit UV-Strahlung mit Leiterbildfotofolie , Entwicklung der Leiter und des kavernenförmigen Leiterhaftgrundes,chemische Verkupferung 1 µm, Beschichtung mit einer 20 µm Schicht des Beschichtungsmittels 1 ohne die Leiterkanäle zu füllen, galvanisch verkupfern der Leiter und Bohrungen, Strippen des Beschichtungsmittels und Ätzen der 1µm Kupferleitschicht.
Leiterplatte : Basismaterial FR 4 1,6 mm unkaschiert R_{Z} 4 µm
Beschichtungsmittel : Beschichtungsmittel 2 verdünnt auf 70% 10Pa.s 25°C
Beschichtungsanlage : Walzenbeschichtungsanlage Figur 1 wie Beispiel 2
Temperatur Auftragswalze : 20 °C
Temperatur Rakel : 90 °C
Temperatur Dosierwalze : 30 °C
Auftragsviskosität : 20 Pa.s
Wannenviskosität : 3 Pa.s
Beschichtungsgeschwindigkeit : 20 m/min
Walzenspalt : 15 µm
Schichtdicke : 11 µm
Trocknung IR 1 bis 10µm 90°C : 60 sek
Belichten UV 360 Lochmaske 20: 60 sek µm
2. Beschichtung : 30 µm wie Beispiel 2
Belichten UV 360 nm(Leiterb.) : 60 sek
Entwickeln Leiter und Haftgrund mit 1% Na₂CO₃ : 90 sek Verkupfern chemisch in den Leiterkanälen und auf der Oberfläche 1 µm
3.Beschichtung : wie Beispiel 3 20µm mit Beschichtungsmittel 1 Galvanisch verkupfern auf 40 µm : 1,8 A/ qdm 60 min
Strippen in 5 %iger KOH ätzen in Ammoniumpersulfat. Weiterverarbeitung zu Multi-Chip -Modulen wie Beispiel 2 und Beispiel 3

## Patentansprüche

1. Verfahren zum Beschichten von Leiterplatten mit einer durch UV-Strahlung vernetzbaren Beschichtung im beidseitigen Walzenbeschichitungsverfahren, dadurch gekennzeichnet, daß die Leiterplatten (11) beschichtungsseitig auf Raumtemperatur gehalten und dann mit einem fotopolymerisierbaren Beschichtungsmittel, welches einen Festkörpergehalt von 70 bis 95 Gew. % und eine Viskosität von 10 bis 60 Pa.s bei 25 °C besitzt, derart beschichtet werden, daß das Beschichtungsmittel mittels auf 25 bis 60 °C temperierter Dosierwalzen (2) in einem Viskositätsbereich von 1 bis 10 Pa.s gehalten und mittels gummierter geschliffener auf eine Oberflächentemperatur von 5 bis 20 °C gekühlter am Rand beschichtungsfrei gehaltener Auftragswalzen (1) mit einer Auftragsviskosität von 20 bis 100 Pa.s und einer Beschichtungsgeschwindigkeit von 5 bis 20 m/min in Schichtdicken von 10 bis 200 µm auf Leiterplattenoberflächen aufgetragen und bei 80 bis 120 °C in 60 bis 120 sek. getrocknet werden.

2. Verfahren nach Anspruch 1 dadurch gekennzeichnet, daß zur Herstellung von Multi-Chip-Modulen, die Leiterplatten (11) mit strahlenvernetzbaren Beschichtungsmitteln (13) in Dicken von 50 bis 100 µm beschichtet und getrocknet werden, durch Belichten mit UV-Strahlung unter Verwendung einer Lochmaske mit Lochdurchmessern von 50 µm und Freientwicklung der nicht vernetzten Lochbereiche (14) Mikrobohrungen (16) entstehen, die nach einer Säureaufrauhung zusammen mit der Oberfläche auf 1 µm chemisch verkupfert werden und daß nach einer zweiten Beschichtung mit einem strahlenvernetzbaren Beschichtungsmittel in einer Schichtdicke von 10 bis 20 µm nach der Trocknung, Fotostrukturierung, Entwicklung, galvanischen Verkupferung auf 10 bis 20 µm (17), Strippen des Beschichtungsmittels und Differenzätzen der 1 µm Kupferschicht (15) IC-Anschlüsse von 100 bis 200 µm Breite über Mikrobohrungen (16) erzeugt werden.

3. Verfahren nach Anspruch 1, dadurch gekennzeichnet, daß mit einer Beschichtung in der Dicke der Leiterhöhe eine Leiterabdeckung von 50 % und eine Leiterkantenabdeckung von 25 % der Beschichtungsdicke erreicht wird.

4. Verfahren nach Anspruch 2, dadurch gekennzeichnet, daß das Beschichtungsmittel einen säurelöslichen und flammenwidrigen Füllstoff, vorzugsweise Magnesiumhydroxid, mit einer Korngröße von 3 bis 10 µm in einer Menge von 10 bis 60 Gew. Teilen enthält.

5. Verfahren nach Anspruch 2, dadurch gekennzeichnet, daß zur Erzeugung eines Leiterhaftgrundes für chemisch abgeschiedene Kupferleiter vor der chemischen Verkupferung der Leiterhaftgrund durch UV-Strahlung derart fotostrukturiert wird, daß nach der Entwicklung der unvernetzten Bereiche zwischen den vernetzten Lochbereichen (28), die sich säulenförmig darstellen, kavernenförmige Vertiefungen (29) entstehen, in denen sich chemisch abgeschiedenes Kupfer haftfest verankern kann.

6. Vorrichtung zum beidseitigen Beschichten von Leiterplatten mit hochviskosen, strahlenvernetzbaren Beschichtungsmitteln mit einer doppelseitigen Walzenbeschichtungsanlage, dadurch gekennzeichnet, daß die Walzenbeschichtungsanlage zwei auf 25 bis 60 °C beheizbare Dosierwalzen (2) und zwei gummierte, mit einer Randabstreifung versehene, auf eine Temperatur von 5 bis 20 °C kühlbare, geschliffene Auftragswalzen (1) aufweist.

7. Vorrichtung nach Anspruch 6, dadurch gekennzeichnet, daß zur Erzeugung eines besichtungsfreien Substratrandes an den gekühlten Auftragswalzen (1) im Randbereich je zwei auf 60 bis 90 °C beheizbare verchromte Rollrakel (4) aus vorzugsweise elektrisch beheizten Metallrollen mit einem Durchmesser von vorzugsweise 10 bis 50 mm angebracht sind und an die Rollrakel Messerrakel (6) als Abstreiforgan anlegbar sind.

8. Vorrichtung nach Anspruch 6, dadurch gekennzeichnet, daß zur randfreien Beschichtung von Leiterplatten die Dosierwalzen (2) mit einem Durchmesser von vorzugsweise 150 mm im Randbereich eine 10 bis 100 mm breite und 10 bis 200 µm dicke galvanisch aufgebrachte Metalldistanzschicht (34) vorzugsweise aus Chrom aufweisen und daß im Randbereich der gummierten, gekühlten Auftragswalzen (1) mit einem Durchmesser von vorzugsweise 200 mm ein Gleitkontaktring (36) in der Dicke der Gumierung angebracht ist, der aus leitfähigem Kunststoff, vorzugsweise aus leitfähigem Schichtpreßstoff besteht, in dessen Schichten Kupferfolien mit Dicken von 35 bis 500 µm eingepreßt wurden, und über den der elektrische Kontakt mit der Metalldistanzschicht (34) gleicher Breite von 2 bis 20 mm herstellbar und die Beschichtungsdicke regelbar ist.

9. Vorrichtung nach Anspruch 6, dadurch gekennzeichnet, daß zum Beschichten von profilierten Substratoberflächen die Gummierung der Auftragswalzen (1) eine Dicke von 10 bis 20 mm und eine Härte von 40 bis 60 shore Härte A mit diagonalen oder oszillierenden Rillen in einer bevorzugten Breite und Tiefe von 100 bis 500 µm besitzen und die Rillen mit einer Gummierung einer Härte von 10 bis 20 shore ausgefüllt und plangeschliffen sind.

10. Vorrichtung nach einem der Ansprüche 6 bis 9, dadurch gekennzeichnet, daß im Anschluß an die Walzenbeschichtungsanlage ein Strahlungs-Konvektions-Laminartrockner angeordnet ist, der über einen horizontalen 20 bis 150 mm hohen und 300 bis 700 mm breiten sowie vorzugsweise 3 bis 10 m langen Trockenkanal (40) verfügt, der zum Leiterplattentransport (9) mittig mit breitenverstellbaren rollengeführten und mit einem Reinigungsbad (12) versehenen Doppelbändern ausgestattet ist, in den Luft am Kanalausgang durch je eine oberhalb und unterhalb der Transporteinrichtung angebrachte Breitschlitzdüse (41) mit unabhängig regelbaren Strömungsgeschwindigkeiten von 5 bis 40 m/s im Gegenstrom zur Transportrichtung eingeblasen wird, und der Trockenkanal (40) auf der Ober- und Unterseite mit Glasscheiben (41) abgedeckt ist, über und unter denen im Abstand von 20 bis 200 mm Infrarotstrahler (42) der Wellenlänge 1 bis 10 µm horizontal und vertikal beweglich angeordnet sind, so daß das Temperaturprofil individuell nach Leiterplatten- und Lackschichtdicke steuerbar ist.

## Claims

1. Method of coating printed circuit boards with a coating, which is cross-linkable by UV radiation, by the bilateral roller coating method, characterised in that the printed circuit boards (11) at their coating sides are kept at ambient temperature and then are so coated with a photopolymerisable coating agent, which has a solids content of between 70 and 95 % by wt. and a viscosity of between 10 and 60 Pa.s at 25° C, that the coating agent is kept in a viscosity range of between 1 and 10 Pa.s by means of metering rollers (2), which are temperature-adjusted to between 25 and 60° C, and the coating agent is applied to printed circuit board surfaces in layer thicknesses of between 10 and 200 µm by means of rubber-coated, ground applicator rollers (1), which are cooled to a surface temperature of between 5 and 20° C and are kept free of coating at the edge, said applicator rollers having an application viscosity of between 20 and 100 Pa.s and a coating speed of between 5 and 20 m/min, and the coating agent is dried at between 80 and 120° C in 60 to 120 secs.

2. Method according to claim 1, characterised in that, in order to produce multi-chip modules, the printed circuit boards (11) are coated with radiation-cross-linkable coating agents (13) in thicknesses of between 50 and 100 µm and dried, microbores (16) are produced by illumination with UV radiation, using a perforated mask provided with perforation diameters of 50 µm, and by a free development of the non-cross-linked perforated regions (14), which microbores, after an acid roughening, are chemically copper-coated together with the surface to 1 µm, and in that, after a second coating with a radiation-cross-linkable coating agent in a layer thickness of between 10 and 20 µm after the drying, photostructuring, development, galvanic copper-coating to between 10 and 20 µm (17), stripping of the coating agent and differential etching of the 1 µm copper layer (15), IC connections with a width of between 100 and 200 µm are produced above microbores (16).

3. Method according to claim 1, characterised in that, with a coating in the thickness of the conductor height, a conductor covering of 50 % and a conductor edge covering of 25 % of the coating thickness are achieved.

4. Method according to claim 2, characterised in that the coating agent contains an acid-soluble and frame-resistant filler, preferably magnesium hydroxide, with a particle size of between 3 and 10 µm in an amount of between 10 and 60 parts by wt.

5. Method according to claim 2, characterised in that, in order to produce a conductor adhesive base for chemically deposited copper conductors prior to the chemical copper-coating, the conductor adhesive base is photostructured by UV radiation in such a manner that, after the development of the non-cross-linked regions between the cross linked perforated regions (28), which are in the form of columns, cavern-shaped depressions (29) are produced, in which chemically deposited copper can be anchored in a firmly adhesive manner.

6. Apparatus for the bilateral coating of printed circuit boards with highly viscous, radiation-cross-linkable coating agents using a bilateral roller coating system, characterised in that the roller coating system has two metering rollers (2), which are heatable to between 25 and 60° C, and two rubber-coated, ground applicator rollers (1), which are provided with an edge stripping and can be cooled to a temperature of between 5 and 20° C.

7. Apparatus according to claim 6, characterised in that, in order to produce a coating-free substrate edge, two chromium-plated roller wipers (4) are mounted on the cooled applicator rollers (1) in the edge region of each, which wipers are heatable to between 60 and 90° C and formed from preferably electrically heated metal rollers with a diameter of preferably between 10 and 50 mm, and wiper blades (6) can be fitted onto the roller wipers as stripping means.

8. Apparatus according to claim 6, characterised in that, for the edge-free coating of printed circuit boards, the metering rollers (2), having a diameter of preferably 150 mm in the edge region, have a galvanically applied metal spacer layer (34), preferably of chromium, which layer has a width of between 10 and 100 mm and a thickness of between 10 and 200 µm, and in that, in the edge region of the rubber-coated, cooled applicator rollers (1) with a diameter of preferably 200 mm, a sliding contact ring (36) is provided in the thickness of the rubber coating and is formed from a conductive plastics material, preferably a conductive moulded laminated plastics material, into the layers of which material copper foils, having thicknesses of between 35 and 500 µm, have been pressed, and via which material the electric contact can be produced with the metal spacer layer (34) of an identical width of between 2 and 20 mm, and the coating thickness is controllable.

9. Apparatus according to claim 6, characterised in that, for the coating of profiled substrate surfaces, the rubber coating of the applicator rollers (1) has a thickness of between 10 and 20 mm and a hardness of between 40 and 60 Shore A hardness with diagonal or oscillating grooves in a preferred width and depth of between 100 and 500 µm, and the grooves are filled with a rubber coating of a hardness of between 10 and 60 Shore and face-ground.

10. Apparatus according to one of claims 6 to 9, characterised in that a radiation-convection laminar drier is disposed after the roller coating system and has a horizontal drying passage (40), which has a height of between 20 and 150 mm, a width of between 300 and 700 mm and preferably a length of between 3 and 10 m, which passage, for the printed circuit board conveyor (9), is provided centrally with width-adjustable, roller-guided double belts provided with a cleaning bath (12), into which bed air at the passage outlet is blown respectively through a wide-slotted nozzle (41), mounted above and below the conveying arrangement, at independently controllable flow speeds of between 5 and 40 m/s in counterflow to the direction of conveyance, and the drying passage (40) is covered on the upper and lower sides with glass plates (41), above and below which, at a spacing of between 20 and 200 mm, infrared radiators (42) having the wavelength between 1 and 10 µm are horizontally and vertically displaceably disposed so that the temperature profile is individually controllable in respect of the printed circuit board and lacquer layer thickness.

## Revendications

1. Procédé permettant de recouvrir des cartes à circuits imprimés d'une couche réticulable par rayonnement ultraviolet selon un procédé de recouvrement au rouleau sur les deux faces, caractérisé en ce que les cartes à circuits imprimés (11) sont maintenues à température ambiante sur la face de la couche puis recouvertes d'un agent de recouvrement photopolymérisable, lequel possède une teneur en solides comprise entre 70 et 95 % en masse et une viscosité comprise entre 10 et 60 Pa.s à 25 °C, de façon telle que l'agent de recouvrement soit maintenu dans une zone de viscosité comprise entre 1 et 10 Pa.s au moyen de rouleaux doseurs (2) régulés entre 25 et 60 °C, appliqué sur la surface des cartes à circuits imprimés en couches d'une épaisseur comprise entre 10 et 200 µm au moyen de rouleaux d'application (1) polis et gommés, exempts d'agent de recouvrement sur les bords, et refroidis pour présenter une température de surface comprise entre 5 et 20 °C, avec une viscosité d'application comprise entre 20 et 100 Pa.s et une vitesse de recouvrement comprise entre 5 et 20 m/min., puis qu'il soit séché en 60 à 120 s à une température comprise entre 80 et 120 °C.

2. Procédé selon la revendication 1, caractérisé en ce que, pour produire des modules multipuces, les cartes à circuits imprimés (11) sont recouvertes d'agents de recouvrement (13) réticulables par rayonnement sur des épaisseurs comprises entre 50 et 100µm, puis séchées, en ce que se forment, par exposition à un rayonnement ultraviolet en utilisant un masque perforé présentant des diamètres de trous de 50µm et développement des zones perforées non réticulées (14), des micro-perforations (16) qui après attaque à l'acide sont chimiquement cuivrées sur 1 µm avec la surface, et en ce que, après une seconde application d'un agent de recouvrement réticulable par rayonnement sur une épaisseur de couche comprise entre 10 et 20 µm, après séchage, photostructuration, développement, cuivrage par électrolyse sur 10 à 20 µm (17), décapage de l'agent de recouvrement et gravure différentielle de la couche de cuivre de 1 µm (15), des connexions de circuits imprimés de 100 à 200 µm de large sont produites par dessus les micro-perforations (16).

3. Procédé selon la revendication 1, caractérisé en ce qu'il est possible d'obtenir, avec une application dans l'épaisseur de la hauteur du conducteur, un recouvrement du conducteur représentant 50 % et un recouvrement des arêtes du conducteur représentant 25 % de l'épaisseur de couche.

4. Procédé selon la revendication 2, caractérisé en ce que l'agent de recouvrement contient un matériau de charge soluble dans l'acide et ininflammable, de préférence de l'hydroxyde de magnésium, présentant une taille de grain comprise entre 3 et 10µm, dans une quantité comprise entre 10 et 60 parties en masse.

5. Procédé selon la revendication 2, caractérisé en ce que, pour produire une couche passivante de conducteur pour conducteurs en cuivre déposés chimiquement, avant le cuivrage chimique, la couche passivante de conducteur est photostructurée par rayonnement ultraviolet de façon telle que, après le développement des zones non réticulées entre les zones perforées réticulées (28), qui se présentent en forme de colonnes, se forment des empreintes (29) en forme de cavités, dans lesquelles le cuivre déposé chimiquement peut s'ancrer par adhésion.

6. Dispositif pour recouvrir les deux faces des cartes à circuits imprimés d'agents de recouvrement très visqueux et réticulables par rayonnement en utilisant un dispositif de recouvrement au rouleau double face, caractérisé en ce que le dispositif de recouvrement au rouleau présente deux rouleaux doseurs (2) pouvant être chauffés entre 25 et 60 °C et deux rouleaux d'application (1) gommés, pourvus d'un dispositif racleur de bords, polis et pouvant être refroidis à une température comprise entre 5 et 20 °C.

7. Dispositif selon la revendication 6, caractérisé en ce que, pour produire un bord de substrat exempt d'agent de recouvrement, sont disposés respectivement contre chaque rouleau d'application refroidi (1), dans la zone des bords, deux racles tournantes chromées (4) pouvant être chauffées entre 60 et 90 °C se composant de préférence de rouleaux métalliques chauffés électriquement et présentant un diamètre compris de préférence entre 10 et 50 mm, et en ce que, contre les racles tournantes peuvent s'appuyer des racles à couteau (6) en tant qu'organes racleurs.

8. Dispositif selon la revendication 6, caractérisé en ce que, pour que les cartes à circuits soient exemptes d'agent de recouvrement sur les bords, les rouleaux doseurs (2) présentant un diamètre de préférence égal à 150 mm présentent dans la zone des bords une couche d'écartement métallique (34) composée de préférence de chrome, appliquée par dépôt électrolytique et présentant une largeur comprise entre 10 et 100 mm et une épaisseur comprise entre 10 et 200 µm, et en ce que, dans la zone des bords des rouleaux d'application gommés et refroidis (1) présentant de préférence un diamètre de 200 mm, est disposée une bague à contact glissant (36) dans l'épaisseur du gommage, laquelle se compose d'un matériau synthétique conducteur, de préférence d'un stratifié, dans les couches de laquelle sont imprimées des feuilles de cuivre présentant une épaisseur comprise entre 35 et 500 mm, et par l'intermédiaire de laquelle le contact électrique avec la couche d'écartement métallique (34) de même largeur entre 2 et 20 mm peut être réalisé et l'épaisseur de la couche de recouvrement ajustée.

9. Dispositif selon la revendication 6, caractérisé en ce que, pour recouvrir des surfaces de substrat profilées, le gommage des rouleaux d'application (1) possède une épaisseur comprise entre 10 et 20 mm et une dureté Shore comprise entre 40 et 60, dureté A, avec des rainures diagonales ou oscillantes d'une largeur et d'une profondeur préférées comprises entre 100 et 500 µm, et en ce que les rainures sont comblées avec un gommage présentant une dureté Shore comprise entre 10 et 20, puis polies.

10. Dispositif selon l'une des revendications 6 à 9, caractérisé en ce qu'en aval du dispositif de recouvrement au rouleau est disposé un séchoir laminaire à rayonnement et à convection, qui est équipé d'un canal de séchage horizontal (40) de 20 à 150 mm de haut et de 300 à 700 mm de large, et de préférence d'une longueur comprise entre 3 et 10 m, lequel est équipé en son milieu, pour le transport des cartes à circuits imprimés (9), de doubles bandes transporteuses avec guidage à rouleaux, réglables en largeur et pourvues d'un bain de rinçage (12), dans lequel est insufflé de l'air au niveau de la sortie du canal et à contre-courant par rapport à la direction du transport, par le biais d'une filière plate (41) amenée au-dessus et en-dessous du dispositif de transport respectivement, avec des vitesses d'écoulement indépendamment réglables et comprises entre 5 et 40 m/s, le canal de séchage (40) étant recouvert sur ses faces supérieure et inférieure de vitres (41), au-dessus et en-dessous desquelles, selon un écart de 20 à 200 mm, sont disposés de façon à pouvoir se déplacer horizontalement et verticalement des radiateurs aux rayons infrarouges (42) de longueur d'onde comprise entre 1 et 10 µm de sorte que le profil de température peut être réglé de façon individuelle en fonction des épaisseurs des cartes à circuits imprimés et des couches de laque.
